(19) **Europäisches Patentamt**
**European Patent Office**
**Office européen des brevets**

(11) **EP 3 147 377 B1**

(12) **EUROPEAN PATENT SPECIFICATION**

(45) Date of publication and mention
of the grant of the patent:
**24.02.2021 Bulletin 2021/08**

(51) Int Cl.:
*C22C 29/08* (2006.01)   *C22C 29/06* (2006.01)
*C23C 14/02* (2006.01)   *C23C 14/06* (2006.01)
*C23C 14/32* (2006.01)   *B23B 27/14* (2006.01)
*B22F 3/24* (2006.01)

(21) Application number: **15795673.1**

(22) Date of filing: **22.05.2015**

(86) International application number:
**PCT/JP2015/064764**

(87) International publication number:
**WO 2015/178484 (26.11.2015 Gazette 2015/47)**

(54) **COATED CEMENTED CARBIDE**

BESCHICHTETES HARTMETALL

CARBURE CÉMENTÉ REVÊTU

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **23.05.2014 JP 2014107436**

(43) Date of publication of application:
**29.03.2017 Bulletin 2017/13**

(73) Proprietor: **Tungaloy Corporation
Iwaki-shi
Fukushima 970-1144 (JP)**

(72) Inventors:
• **ORI, Shinya
Iwaki-shi,
Fukushima 970-1144 (JP)**
• **FUNAMIZU, Kenji
Iwaki-shi,
Fukushima 970-1144 (JP)**

(74) Representative: **Vossius & Partner
Patentanwälte Rechtsanwälte mbB
Siebertstrasse 3
81675 München (DE)**

(56) References cited:
**EP-A1- 2 267 185**      **EP-A2- 1 452 621**
**JP-A- H09 295 204**    **JP-A- 2005 336 565**
**JP-A- 2007 203 450**   **JP-A- 2009 220 260**
**JP-A- 2010 521 324**   **JP-A- 2012 066 336**
**JP-A- 2012 086 297**   **JP-A- 2013 111 711**
**US-A1- 2013 105 231**

• **A F Lisovskii: "SINTERED METALS AND ALLOYS
CEMENTED CARBIDES ALLOYED WITH
RUTHENIUM, OSMIUM, AND RHENIUM", Powder
Metallurgy and Metal Ceramics, 1 September
2000 (2000-09-01), pages 9-10, XP055297741,
DOI: 10.1023/A:1011306204246 Retrieved from
the Internet:
URL:http://download.springer.com/static/pd
f/175/art%3A10.1023%2FA%3A1011306204246.p
d f?originUrl=http://link.springer.com/artic
le/10.1023/A:1011306204246&token2=exp=1472
132221~acl=/static/pdf/175/art%253A10.1023
%252FA%253A1011306204246.pdf?originUrl=ht
t
p%3A%2F%2Flink.springer.com%2Farticle%2F1
0 .1023%2FA% [retrieved on 2016-08-25]**

EP 3 147 377 B1

**Description**

TECHNICAL FIELD

The present invention relates to a coated cemented carbide. In particular, it relates to a coated cemented carbide having excellent cutting properties for processing of difficult-to-cut materials.

BACKGROUND ART

A titanium alloy used for aircraft parts, etc., and a heat resistant alloy (for example, Inconel (registered trademark)) used for turbine blades of a generator have been known to be difficult-to-cut materials. Chances to process such difficult-to-cut materials by cutting are increasing. In the processing of the difficult-to-cut materials, a work piece material is welded to the cutting tool, so that fracture sometimes occurs in the cutting tool. Thus, in the processing of the difficult-to-cut materials, tool life is extremely shorter than that in the processing of general steel materials. Therefore, it has been required to increase strength of the cutting tool for elongating the life of the cutting tool even in the processing of the difficult-to-cut materials.

As a prior art technique of a cemented carbide, for example, techniques disclosed in JP 2010 207955 A and JP 2004 181604 A have been known.

In JP 2010 207955 A, it has been disclosed a method in which Co in a binder phase of a face-centered cubic structure is partially transformed into a hexagonal close-packed structure by an air blasting treatment. According to this method, compression stress is introduced into a cemented carbide whereby fracture resistance of the cemented carbide can be improved.

In JP 2004 181604 A, it has been disclosed a method in which toughness, corrosion resistance and thermal shock resistance of a cemented carbide are improved by adding Ru to a binder phase.

US 2013/0105231 A1 discloses an earth boring cutting insert including a cemented carbide comprising metal carbide grains dispersed in a metallic binder including at least one of platinum, palladium, rhenium, rhodium, and ruthenium.

A. F. Livoskii, "SINTERED METALS AND ALLOYS CEMENTED CARBIDES ALLOYED WITH RUTHENIUM, OSMIUM, AND RHENIUM", Powder Metallurgy and Metal Ceramics, Vol. 39, Nos. 9-10, 2000, pages 428-432 discloses a study of the structure and mechanical properties of WC-Co cemented carbides alloyed with Ru, Re, and Os.

EP 1 452 621 A2 discloses a cutting tool insert comprising a substrate and a coating. The coating is composed of one or more layers of refractory compounds.

SUMMARY OF THE INVENTION

Problems to be Solved by the Invention

However, in the processing of the difficult-to-cut materials such as a Ni-based alloy and a Ti-based alloy, etc., high heat is generated at a cutting edge part. In a high speed heavy cutting work with high feeding and deep cutting, a high load is applied to the cutting edge part, so that cutting chips are likely welded to the cutting edge part. When the welded cutting chips are peeled off, extremely minute chipping is accompanied. By the above phenomenon being repeated, chipping and fracture are generated at the cutting edge part. In addition, by reacting a cemented carbide and a work piece material, diffusion wear proceeds. When the diffusion wear proceeds, strength of the cutting edge part is lowered, so that the cutting tool is fractured within a short period of time.

In the above-mentioned document JP 2010 207955 A, there is disclosed a cemented carbide in which Co in the binder phase is partially transformed into a hexagonal close-packed structure. This cemented carbide is inferior in heat resistance since the melting point of Co in the binder phase is low. Therefore, this cemented carbide involves the problem that diffusion wear is likely to be progressed, and the tool life is short.

In the above-mentioned JP 2004 181604 A, there is disclosed a cemented carbide in which Ru is added to the binder phase. In this cemented carbide, a ratio of the crystal structure of Co in the binder phase is not controlled. Therefore, this cemented carbide involves the problem that compression stress is not generated in the base material, so that it is inferior in fracture resistance.

The present invention has been done to solve the above-mentioned problems, and an object thereof is to provide a coated cemented carbide having excellent fracture resistance when they are used as a cutting tool.

Means to Solve the Problems

The present inventors have carried out various investigations on a cemented carbide and a coated cemented carbide. As a result, the present inventors have clarified that a cemented carbide having excellent fracture resistance can be obtained by devising a composition of the binder phase of a cemented carbide, whereby they have reached the present invention. Further, adhesiveness of the coating layer is improved by devising a coating layer formed onto the surface of the cemented carbide. As a result, a coated cemented carbide having excellent fracture resistance can be obtained.

The present invention is defined by independent claim 1, and further embodiments of the invention are specified in dependent claims 2-4.

The coated cemented carbide of the present invention comprises a cemented carbide comprising a hard phase containing tungsten carbide as a main component and a binder phase. A ratio of the hard phase based on the whole cemented carbide (100% by mass) is 85 to 97% by mass, and the remainder being the binder phase.

If the ratio of the hard phase is less than 85% by mass, wear resistance of the cemented carbide is lowered. If the ratio of the hard phase exceeds 97% by mass, fracture resistance of the cemented carbide is lowered. Also, if the ratio of the hard phase exceeds 97% by mass, an amount of the remainder binder phase is relatively reduced, so that sinterability of raw materials at the time of producing the cemented carbide is lowered. Accordingly, a ratio of the hard phase is 85 to 97% by mass. A ratio of the hard phase is further preferably 86 to 92% by mass. The binder phase occupies the remainder other than the hard phase.

A main component of the hard phase of the cemented carbide of the present invention is tungsten carbide. The main component means that it is contained in an amount exceeding 50% by mass when the whole hard phase is 100% by mass. The whole hard phase may comprise tungsten carbide alone. The hard phase may contain other components than the tungsten carbide. The hard phase may contain a compound comprising at least one kind of a metal element selected from the group consisting of Ti, Zr, Hf, V, Nb, Ta, Cr and Mo, and at least one kind of an element selected from C and N. If the hard phase contains such a compound, wear resistance and plastic deformation resistance of the cemented carbide are improved.

An average grain diameter of the hard phase of the cemented carbide of the present invention is 0.5 $\mu$m or more and 5.0 $\mu$m or less. If the average grain size of the hard phase is less than 0.5 $\mu$m, hardness of the cemented carbide is high, so that fracture resistance of the cemented carbide tends to be lowered. If the average grain size of the hard phase exceeds 5.0 $\mu$m, hardness of the cemented carbide is lowered, so that wear resistance of the cemented carbide tends to be lowered.

An average grain diameter of the hard phase of the cemented carbide of the present invention is obtained by observing the polished cross-section of the cemented carbide. Such a cross-section can be obtained by mirror polishing an optional cross-section of the cemented carbide. For mirror polishing the cemented carbide, for example, diamond paste, colloidal silica, or ion milling may be used. The average grain diameter of the hard phase is obtained by applying the Fullman's equation (1) to the image in which the cross-sectional structure of the cemented carbide is enlarged by SEM to 2,000 to 10,000-fold.

$$d=(4/\pi)\cdot(NL/NS) \qquad (1)$$

wherein d is an average grain size, $\pi$ is the circular constant, NL is a number of the hard phase per a unit length hit by an optional straight line on a cross-sectional structure, and NS is a number of the hard phase contained in an optional unit area.

The binder phase of the cemented carbide of the present invention contains Co, and at least one kind of the platinum group element selected from the group consisting of Ru, Rh, Pd, Os, Ir and Pt. When the binder phase contains Co, sinterability is improved. According to this constitution, toughness of the cemented carbide is improved, and fracture resistance of the cemented carbide is improved. In addition, by containing the platinum group element in the binder phase, heat resistance of the cemented carbide is improved. According to this constitution, progress of diffusion wear is suppressed, and fracture due to insufficiency of strength at the cutting edge part is suppressed.

The binder phase of the cemented carbide of the present invention contains Co in an amount of 2.5% by mass or more and 14.5% by mass or less, and the platinum group element in an amount of 0.5% by mass or more and 4% by mass or less.

If the contents of Co and the platinum group element are within the above ranges, fracture resistance and heat resistance of the cemented carbide tend to be improved. If the content of Co is less than 2.5% by mass, fracture resistance of the cemented carbide tends to be lowered. Also, if the content of Co is less than 2.5% by mass, the ratio of the platinum group element is relatively increased, so that the binder phase is embrittled and fracture resistance of the cemented carbide tends to be lowered. If the content of Co exceeds 14.5% by mass, wear resistance of the cemented carbide is lowered. Also, if the content of Co exceeds 14.5% by mass, the ratio of the platinum group element is relatively decreased, so that heat resistance of the cemented carbide tends to be lowered. Further, if the content of the platinum group element is less than 0.5% by mass, heat resistance of the cemented carbide tends to be lowered. If the ratio of the platinum group element exceeds 4% by mass, the binder phase is markedly embrittled, so that fracture resistance of the cemented carbide tends to be lowered. The binder phase of the cemented carbide of the present invention preferably further contains W in an amount of 2% or more and 9% or less. If the content of W is within the range, wear resistance of the cemented carbide is improved.

The ratio and the respective compositions of the hard phase and the binder phase of the cemented carbide can be obtained as follows.

A cross-sectional structure of the cemented carbide from the surface to 500 $\mu$m in the depth direction is observed by a scanning electron microscope (SEM) attached with an energy dispersive X-ray spectroscopy (EDS). By using EDS, each composition of the hard phase and the binder phase of the cemented carbide is measured. From the measured results, a ratio of the hard phase and the binder phase of the cemented carbide can be obtained.

Peaks of Co obtained by X-ray diffraction analysis of the binder phase of the present invention have the following characteristics.

An intensity at the (200) plane of cubic Co is made $I_{Coc}$.

An intensity at the (101) plane of hexagonal Co is made $I_{Coh}$.

The ratio of $I_{coh}$ based on the total of $I_{Coc}$ and $I_{Coh}$ is 0.1 or more and 0.6 or less.

$$0.1 \leq [I_{Coh}/(I_{Coh}+I_{Coc})] \leq 0.6$$

If $I_{Coh}/(I_{Coh}+I_{Coc})$ is less than 0.1, an existing ratio of the hexagonal Co is small, so that sufficient compression stress is not provided into the cemented carbide, whereby fracture resistance of the cemented carbide is lowered.

If $I_{Coh}/(I_{Coh}+I_{Coc})$ exceeds 0.6, compression stress in the cemented carbide is large. As a result, crack is likely generated during cutting, and fracture resistance of the cemented carbide is lowered.

Therefore, $I_{Coh}/(I_{Coh}+I_{Coc})$ is preferably 0.1 or more and 0.6 or less.

With regard to the binder phase of the present invention, the intensity $I_{Coc}$ at the (200) plane of the cubic Co and the intensity $I_{coh}$ at the (101) plane of the hexagonal Co can be measured by using a commercially available X-ray diffractometer. For the measurement of the intensities $I_{Coc}$ and $I_{Coh}$, for example, an X-ray diffractometer RINT TTRIII manufactured by Rigaku Corporation can be used. Also, for the measurement, X-ray diffraction measurement of a $2\theta/\theta$ concentrated optical system using a Cu-Ka line can be used. The measurement conditions of the X-ray diffraction are, for example, as follows.

Output: 50 kV, 250 mA,
Solar slit at incident side: 5°,
Divergence vertical slit: 2/3°,
Divergence vertical limit slit: 5 mm,
Scattering slit: 2/3°,
Solar slit at photoreception side: 5°,
Photoreception slit: 0.3 mm,
BENT monochromator,
Photoreception monochrome slit: 0.8 mm,
Sampling width: 0.01°,
Scanning speed: 1°/min,
$2\theta$ measurement range: 30 to 60°

From the X-ray diffraction chart, the intensity $I_{Coc}$ at the (200) plane of cubic Co and the intensity $I_{Coh}$ at the (101) plane of the hexagonal Co can be obtained. At this time, an analysis software attached to the X-ray diffractometer may be used. When the analysis software is used, background processing and K$\alpha$2 peak removal are carried out by using a cubic approximation, and profile fitting is carried out by using a Pearson-VII function. According to this procedure, the intensity $I_{Coc}$ at the (200) plane of cubic Co and the intensity $I_{coh}$ at the (101) plane of the hexagonal Co can be obtained.

Further, a coating layer is formed onto the surface of the cemented carbide of the present invention. By forming a coating layer onto the surface of the cemented carbide, wear resistance of the cemented carbide is improved.

The coating layer of the present invention may be one layer, or may be a multi-layer.

If the average thickness of the whole coating layer of the present invention is less than 0.5 $\mu$m, wear resistance of the coating layer tends to be lowered. If the average thickness of the whole coating layer exceeds 10 $\mu$m, fracture resistance of the coating layer tends to be lowered. Therefore, the average thickness of the whole coating layer is preferably 0.5 $\mu$m or more and 10 $\mu$m or less.

The coating layer of the present invention is constituted by a compound comprising at least one kind of an element selected from the group consisting of Ti, Zr, Hf, V, Nb, Ta, Cr, Mo, W, Al, Si and Y, and at least one kind of an element selected from the group consisting of C, N, B and O. If the coating layer is constituted by such a compound, wear resistance of the coating layer is improved.

The coating layer of the present invention contains at least one adhesive layer. The adhesive layer is formed onto the surface of the cemented carbide. If the coating layer contains the adhesive layer, adhesiveness between the cemented carbide and the coating layer is improved.

Also, the coating layer of the present invention may contain at least one upper layer. The upper layer is formed onto the surface of the adhesive layer. The upper layer is preferably constituted by a compound comprising at least one kind of an element selected from the group consisting of Ti, Zr, Hf, V, Nb, Ta, Cr, Mo, W, Al, Si and Y, and at least one kind of an element selected from the group consisting of C, N, B and O. The upper layer is preferably a single layer or laminated layers comprising such a compound. When the coating layer contains the upper layer, wear resistance of the coating layer is improved.

The adhesive layer of the present invention contains cubic structure and hexagonal structure. Peaks of the adhesive layer obtained by an X-ray diffraction analysis have the following features.

An intensity at a (200) plane of cubic structure is made $I_c$.

An intensity at a (100) plane of hexagonal structure is made $I_h$.

A ratio of $I_h$ based on the total of $I_c$ and $I_h$ is 0.05 or more and 0.3 or less.

$$0.05 \leqq [I_h/(I_h+I_c)] \leqq 0.3$$

When the peaks of the adhesive layer have the above-mentioned features, adhesiveness between the cemented carbide and the coating layer is improved.

If $I_h/(I_h+I_c)$ is less than 0.05, an existing ratio of the hexagonal structure is small, so that adhesiveness between the cemented carbide and the coating layer tends to be lowered. In this case, minute chipping which becomes an origin of fracture cannot be suppressed.

If $I_h/(I_h+I_c)$ exceeds 0.3, strength of the adhesive layer is lowered, so that fracture resistance tends to be lowered.

An adhesive layer containing hexagonal structure is formed onto the surface of the cemented carbide containing the hexagonal Co. According to this constitution, adhesiveness between the cemented carbide and the adhesive layer is remarkably improved. In addition, minute chipping which becomes an origin of fracture can be suppressed.

With regard to the adhesive layer of the present invention, the intensity $I_c$ at the (200) plane of cubic structure and the intensity $I_h$ at the (100) plane of hexagonal structure can be measured by using a commercially available X-ray diffractometer. For the measurement of the intensities $I_c$ and $I_h$, for example, an X-ray diffractometer RINT TTRIII manufactured by Rigaku Corporation can be used. Also, for the measurement, X-ray diffraction measurement of a $2\theta/\theta$ concentrated optical system using a Cu-Ka line can be used. The measurement conditions of the X-ray diffraction are, for example, as follows.

Output: 50 kV, 250 mA,
Solar slit at incident side: 5°,
Divergence vertical slit: 2/3°,
Divergence vertical limit slit: 5 mm,
Scattering slit: 2/3°,
Solar slit at photoreception side: 5°,
Photoreception slit: 0.3 mm,
BENT monochromator,
Photoreception monochrome slit: 0.8 mm,
Sampling width: 0.01°,
Scanning speed: 1°/min, 2θ measurement range: 30 to 70°.

From the X-ray diffraction chart, the intensity $I_c$ at the (200) plane of cubic structure and the intensity $I_h$ at the (100) plane of the hexagonal structure can be obtained. At this time, an analysis software attached to the X-ray diffractometer may be used. When the analysis software is used, background processing and Kα2 peak removal are carried out by using a cubic approximation, and profile fitting is carried out by using a Pearson-VII function. According to this procedure, the intensity $I_c$ at the (200) plane of cubic structure and the intensity $I_h$ at the (100) plane of the hexagonal structure can be obtained.

Incidentally, when the upper layer is formed onto the surface of the adhesive layer, after removing the upper layer by polishing until the adhesive layer is exposed, the exposed adhesive layer is measured by using an X-ray diffractometer.

The adhesive layer of the present invention has a composition represented by $Al_xTi_yM_zN$. If the adhesive layer has such a composition, minute chipping which becomes an origin of fracture can be suppressed. In the formula, M represents at least one kind of an element selected from the group consisting of Zr, Hf, V, Nb, Ta, Cr, Mo, W, Y, B and Si, x represents an atomic ratio of an Al element based on the total of an Al element, a Ti element and an M element, y represents an atomic ratio of a Ti element based on the total of an Al element, a Ti element and an M element, z represents an atomic ratio of an M element based on the total of an Al element, a Ti element and an M element, and x, y, and z satisfy $0.65 \leqq x \leqq 0.9$, $0.1 \leqq y \leqq 0.35$, $0 \leqq z \leqq 0.2$, and $x+y+z=1$. When x, y, and z satisfy such conditions, balance between fracture resistance, wear resistance and oxidation resistance becomes good.

An average thickness of the adhesive layer of the present invention is further preferably 0.5 $\mu$m or more and 7 $\mu$m or less. If the average thickness of the adhesive layer is less than 0.5 $\mu$m, wear resistance tends to be lowered. If the average thickness of the adhesive layer exceeds 7 $\mu$m, fracture resistance tends to be lowered.

A thickness of the each layer constituting the coating layer of the present invention can be measured by observing the cross-sectional structure of the coated cemented carbide. A thickness of the whole coating layer can be also measured by observing the cross-sectional structure of the coated cemented carbide. The cross-sectional structure of the coated cemented carbide can be observed by using, for example, an optical microscope, a scanning electron microscope (SEM), or a transmission electron microscope (TEM). The average thickness of each layer constituting the coating layer is a value in which the thickness of each layer is measured at three or more points of the cross-sectional surface of the coating layer, and an average value thereof is calculated. The thickness of the whole coating layer is a value in which the thickness of the whole coating layer is measured at three or more points of the cross-sectional surface of the coating layer, and an average value thereof is calculated.

The average grain diameter of the adhesive layer of the present invention is preferably 10 nm or more and 400 nm or less. If the average grain size is less than 10 nm, wear resistance tends to be lowered. If the average grain size exceeds 400 nm, adhesiveness tends to be lowered, and minute chipping which becomes an origin of fracture cannot be suppressed.

The grain diameter of the adhesive layer of the present invention can be obtained by observing the cross-sectional structure of the adhesive layer which is parallel to the surface of the coated cemented carbide.

More specifically, the adhesive layer is mirror-polished in parallel to the surface of the coated cemented carbide. According to this procedure, a cross-sectional structure of the adhesive layer can be obtained. At this time, the adhesive layer can be mirror-polished from the surface of the adhesive layer toward the inside thereof. Or else, the adhesive layer can be mirror-polished from the interface between the adhesive layer and the upper layer toward the inside thereof. By mirror-polishing the adhesive layer until the unevenness at the surface is eliminated, cross-sectional structure of the adhesive layer can be obtained.

For obtaining the grain diameter of the adhesive layer, the cross-sectional structure in the vicinity of the surface of the adhesive layer may be observed. Or else, for obtaining the grain diameter of the adhesive layer, the cross-sectional structure at the inside of the adhesive layer may be observed.

The adhesive layer may be mirror-polished, for example, by using a method of polishing using a diamond paste or colloidal silica, or by using an ion milling.

By observing the cross-sectional structure excluding droplets having a diameter of 100 nm or more, the grain diameter of the adhesive layer can be obtained. For observation of the cross-sectional structure, for example, FE-SEM, TEM, or an electron backscatter diffraction device (EBSD) may be used. The grain diameter of the adhesive layer means a diameter of a circle (circle equivalent diameter) of an area equal to an area of a grain constituting the adhesive layer.

For obtaining the grain diameter from the cross-sectional structure of the adhesive layer, an image analysis software may be used. In the cross-sectional structure of the adhesive layer, the droplets having a diameter of 100 nm or more and the area other than the droplets can be easily distinguished.

When the cross-sectional structure of the adhesive layer is observed, the droplets are circular. At around the droplets, voids having a thickness of several nm to several tens nm are present. The droplets sometimes fall out from the adhesive layer during the mirror polishing. In such a case, a circular hole is generated at the cross-sectional structure of the adhesive layer. Thus, in the cross-sectional structure of the adhesive layer, the droplets having a diameter of 100 nm or more and the area other than the droplets can be easily distinguished.

When an upper layer is formed at the surface side of the adhesive layer, it is preferable to mirror-polish the upper layer until the adhesive layer is exposed. At this time, it is preferable to mirror-polish the upper layer from the surface of the upper layer toward the inside thereof. After the adhesive layer is exposed, it is preferable to mirror-polish the adhesive layer until the unevenness of the surface is eliminated.

The main component of the coated cemented carbide of the present invention is tungsten carbide comprising hexagonal structure. The binder phase of the cemented carbide of the present invention contains hexagonal Co. An adhesive layer containing cubic structure and hexagonal structure is formed onto the surface of the cemented carbide of the present invention. According to the present invention, adhesiveness between the cemented carbide and the adhesive layer is improved. As a result, in the processing of difficult-to-cut materials such as Inconel (registered trademark), etc., fracture caused by minute chipping which becomes an origin of the fracture and generates at the time of peeling of welded cutting chips can be suppressed.

The adhesive layer of the present invention may be formed by the chemical vapor deposition method, or may be formed by the physical vapor deposition method. The adhesive layer of the present invention is preferably formed by the physical vapor deposition method. The physical vapor deposition method may be, for example, an arc ion plating method, an ion plating method, a sputtering method or an ion mixing method. Among these, the arc ion plating method is more preferable since adhesiveness between the cemented carbide and the coating layer can be improved.

Next, a method for producing the cemented carbide of the present invention is explained by using specific examples. Incidentally, the method for producing the cemented carbide of the present invention is not particularly limited as long as the constitution of the cemented carbide can be accomplished.

The method for producing the cemented carbide of the present invention includes, for example, the following Processes (A) to (F).

Process (A): a process of preparing the following powders (1) to (4) so that the total of which becomes 100% by mass.

(1) Tungsten carbide powder having an average grain size of 0.5 to 5.0 $\mu$m: 85 to 97% by mass

(2) Optionally, at least one kind of powder selected from the group consisting of a carbide, a nitride and a carbonitride of at least one kind of a metal element selected from the group consisting of Ti, Zr, Hf, V, Nb, Ta, Cr and Mo having an average grain size of 0.5 to 5.0 $\mu$m with an amount so that the total of (1) to (4) becomes 100% by mass

(3) Co powder having an average grain size of 0.5 to 3.0 $\mu$m: 2.5 to 14.5% by mass

(4) At least one kind of a platinum group element powder selected from the group consisting of Ru, Rh, Pd, Os, Ir and Pt having an average grain size of 1.0 to 10.0 $\mu$m: 0.5 to 4.0% by mass

Process (B): a mixing process in which the powder prepared in Process (A) is mixed by a wet ball mill for 10 to 40 hours.

Process (C): a molding process in which the mixture obtained in Process (B) is molded to a predetermined tool shape.

Process (D): a first temperature raising process in which a temperature of the molded product obtained in Process (C) is raised to a temperature of 1,400 to 1,550°C in a vacuum of 70 Pa or lower.

Process (E): a first sintering process in which the molded product obtained in Process (D) is sintered at a temperature of 1,400 to 1,550°C for 30 to 120 minutes in an inert gas atmosphere of 100 to 1,330 Pa.

Process (F): a cooling process in which the molded product obtained in Process (E) is cooled in a vacuum of 70 Pa or lower from a temperature of 1400 to 1550°C to normal temperature with a rate of 5 to 30°C/min.

Incidentally, an average grain size of the raw material powder used in Process (A) is measured by the Fisher method (Fisher Sub-Sieve Sizer (FSSS)) described in American Society for Testing and Materials (ASTM) Standard B330.

Processes (A) to (F) have the following meanings.

In Process (A), (1) tungsten carbide powder, (2) at least one kind of powder selected from the group consisting of a carbide, a nitride and a carbonitride of at least one kind of a metal element selected from the group consisting of Ti, Zr, Hf, V, Nb, Ta, Cr and Mo, (3) Co powder, and (4) at least one kind of a platinum group element powder selected from the group consisting of Ru, Rh, Pd, Os, Ir and Pt are used. According to this constitution, a cemented carbide having a specific composition can be obtained.

In the cemented carbide of the present invention, the platinum group element is dissolved in Co, and transformation to hexagonal Co tends to be generated. Also, when the dissolved amount of the platinum group element in Co is larger, the ratio of transforming to hexagonal Co tends to be higher. For obtaining the cemented carbide of the present invention, it is preferred to adjust a blending ratio of Co and the platinum group element [the platinum group element (% by mass)/Co (% by mass)] to 0.1 to 0.6.

In Process (B), an average grain size of the hard phase can be adjusted. In Process (B), the raw material powder prepared in Process (A) can be uniformly mixed.

In Process (C), the obtained mixture is molded to a predetermined tool shape. The obtained molded product is sintered in the following sintering process.

In Process (D), a temperature of the molded product is raised in a vacuum of 70 Pa or lower. According to this procedure, degassing is promoted before appearance of the liquid phase and immediately after appearance of the liquid phase, and sinterability in the following sintering process is improved.

In Process (E), the molded product is sintered at a temperature of 1,400 to 1,550°C. According to this procedure, the molded product becomes dense and mechanical strength of the molded product is increased.

In Process (F), the molded product is gradually cooled in a vacuum of 70 Pa or lower from a temperature of 1,400 to 1,550°C to normal temperature with a rate of 5 to 30°C/min. According to this procedure, transformation from cubic Co to hexagonal Co occurs. By controlling the transformed amount from the cubic Co to the hexagonal Co, the cemented carbide of the present invention can be obtained. In the cemented carbide of the present invention, a platinum group element is dissolved in Co, so that transformation to the hexagonal Co likely proceeds. If no platinum group element is dissolved in Co, even when the sintered body is gradually cooled after sintering, transformation to the hexagonal Co does not substantially proceed.

If a blending ratio of Co and the platinum group element is large, an amount of transformation from the cubic Co to the hexagonal Co becomes large. If the cooling rate from the sintering temperature to normal temperature is slow, an amount of transformation from the cubic Co to the hexagonal Co becomes large. By adjusting the blending ratio of Co and the platinum group element within the range of 0.1 to 0.6, the amount of transformation from the cubic Co to the hexagonal Co can be controlled. Further, by adjusting the cooling rate from the sintering temperature to normal temperature within the range of 5 to 30°C/min, the amount of transformation from the cubic Co to the hexagonal Co can be controlled.

More specifically, when the blending ratio of the platinum group element is large, and the amount of transformation to the hexagonal Co is too much, the cooling rate is made faster. When the blending ratio of the platinum group element is a little, and the amount of transformation to the hexagonal Co is too little, the cooling rate is made slow. By adjusting the blending ratio of Co and the platinum group element and the cooling rate, a ratio of the cubic Co and the hexagonal Co can be adjusted. According to such an adjustment, the ratio of $I_{Coh}$ based on the total of $I_{Coc}$ and $I_{coh}$ can be controlled.

Grinding or honing of a cutting edge may be applied to the cemented carbide obtained by Process (A) through Process (F), if necessary.

Next, a method for producing the coated cemented carbide of the present invention is explained by referring to specific examples. Incidentally, the method for producing the coated cemented carbide of the present invention is not particularly limited as long as the constitution of the coated cemented carbide can be accomplished.

The cemented carbide of the present invention processed to a tool shape is charged in a reaction vessel of a physical deposition device.

Inside of the reaction vessel is evacuated to a pressure of $1 \times 10^{-2}$ Pa or lower.

After evacuation, the cemented carbide is heated to a temperature of 200 to 800°C by a heater in the reaction vessel.

After heating, an Ar gas is introduced into the reaction vessel to adjust the pressure in the reaction vessel to 0.5 to 5.0 Pa.

Under an Ar gas atmosphere of a pressure of 0.5 to 5.0 Pa, a bias voltage with -200 to -1,000V is applied to the cemented carbide.

The surface of the cemented carbide is subjected to an ion bombardment treatment by an Ar gas by passing a current of 5 to 20A through a tungsten filament in the reaction vessel.

After the surface of the cemented carbide is subjected to the ion bombardment treatment, inside of the reaction vessel is evacuated to a pressure of $1 \times 10^{-2}$ Pa or lower.

Next, the cemented carbide is heated to a temperature of 200°C to 600°C.

Thereafter, a reaction gas such as a nitrogen gas, etc., is introduced into the reaction vessel, and a pressure in the reaction vessel is adjusted to 0.5 to 5.0 Pa. A bias voltage of -10 to -150V is applied to the cemented carbide. A metal evaporation source corresponding to a metal component(s) of each layer is evaporated by an arc discharge of 80 to 150A. According to this procedure, each layer can be formed onto the surface of the cemented carbide.

The adhesive layer of the present invention can be formed, for example, by the following method.

A metal evaporation source is set in the reaction vessel. An atomic ratio of an Al element based on the total of the Al element, a Ti element and an M element contained in the metal evaporation source is 0.65 or more. The surface of the cemented carbide is subjected to the ion bombardment treatment. After the ion bombardment treatment, the cemented carbide is heated to a temperature of 700°C to 900°C. Thereafter, a reaction gas such as a nitrogen gas, etc., is introduced into the reaction vessel, and a pressure in the reaction vessel is adjusted to 0.5 to 3.0 Pa. A bias voltage of -10 to -40V is applied to the cemented carbide. A metal evaporation source corresponding to a metal component(s) of each layer is evaporated by an arc discharge of 80 to 100A. According to this procedure, nuclei of the adhesive layer are formed by dispersing them onto the surface of the cemented carbide with a thickness of 20 to 100 nm (nuclei forming process). After the nuclei forming process, a bias voltage of -80 to -150V is applied to the cemented carbide. A metal evaporation source corresponding to a metal component(s) of each layer is evaporated by an arc discharge of 100 to 150A. According to this procedure, the adhesive layer can be formed onto the surface of the cemented carbide (film forming process). Incidentally, a thickness of the nuclei of the adhesive layer can be obtained from a nuclei growing rate per a unit time in the nuclei forming process.

An atomic ratio of an Al element based on the total of the Al element, a Ti element and an M element contained in the metal evaporation source is made large to increase the ratio of the hexagonal structure in the adhesive layer.

According to this procedure, the thickness of the nuclei of the adhesive layer becomes thin, so that the ratio of the hexagonal structure contained in the adhesive layer can be increased.

Effects of the Invention

The coated cemented carbide of the present invention have excellent fracture resistance. The coated cemented carbide of the present invention exhibit excellent performances particularly in cutting of difficult-to-cut materials. Therefore, the coated cemented carbide of the present invention are suitable for a constituting material of a tool.

[Example 1]

[Manufacture of cemented carbide]
As raw material powders, commercially available powders mentioned below were prepared.

Tungsten carbide powder having an average grain size of 3.0 $\mu$m,
Tungsten carbide powder having an average grain size of 5.0 $\mu$m,
Tungsten carbide powder having an average grain size of 7.5 $\mu$m,
$Cr_3C_2$ powder an average grain size of 1.5 $\mu$m,
(Ti,Ta)C powder having an average grain size of 1.5 $\mu$m,
Co powder having an average grain size of 1.5 $\mu$m,
Ru powder having an average grain size of 2.0 $\mu$m,
Ir powder having an average grain size of 2.0 $\mu$m,
Rh powder having an average grain size of 2.0 $\mu$m

Incidentally, the average grain size of the raw material powder is measured by the Fisher method (Fisher Sub-Sieve Sizer (FSSS)) described in American Society for Testing and Materials (ASTM) Standard B330.
The prepared raw material powders were weighed so that they satisfy the blending ratio shown in the following Table 1. The weighed raw material powders were charged in a pot made of a stainless streel with an acetone solvent and balls made of a cemented carbide. The raw material powders were mixed and pulverized by a wet ball mill for 10 to 40 hours. After mixing and pulverization by the wet ball mill, the acetone solvent was evaporated. The mixture evaporated the acetone solvent was press-molded with a pressure of 196 MPa. The metal mold used for the press-molding is a metal mold in which a shape of the molded product after sintering is an ISO standard insert shape of RPHT10T3.

[Table 1]

| Sample No. | Composition (% by mass) | Ratio of Co and platinum group element [Platinum group element (% by mass)/ Co (% bv mass)] |
|---|---|---|
| Present product 1 | 85%WC, 13%Co, 2%Ru | 0.15 |
| Present product 2 | 88%WC, 10%Co, 2%Ru | 0.20 |
| Present product 3 | 90%WC, 8.7%Co, 1.3%Ru | 0.15 |
| Present product 4 | 90%WC, 8.7%Co, 1.3%Ru | 0.15 |
| Present product 5 | 90%WC, 8.7%Co, 1.3%Ru | 0.15 |
| Present product 6 | 90%WC, 8.7%Co, 1.3%Ru | 0.15 |
| Present product 7 | 92%WC, 5%Co, 3%Ru | 0.60 |
| Present product 8 | 97%WC, 2.5%Co, 0.5%Ru | 0.20 |
| Present product 9 | 89.2%WC, 0.8%$Cr_3C_2$, 8.7%Co, 1.3%Ru | 0.15 |
| Present product 10 | 89.2%WC, 0.8%$Cr_3C_2$, 8.7%Co, 1.3%Ru | 0.15 |
| Present product 11 | 87.8%WC, 2.2%(Ti,Ta)C, 8.7%Co, 1.3%Ru | 0.15 |
| Present product 12 | 87.8%WC, 2.2%(Ti,Ta)C, 8.7%Co, 1.3%Ru | 0.15 |

(continued)

| Sample No. | Composition (% by mass) | Ratio of Co and platinum group element [Platinum group element (% by mass)/ Co (% bv mass)] |
|---|---|---|
| Present product 13 | 90%WC, 8.7%Co, 1.3%Rh | 0.15 |
| Present product 14 | 90%WC, 8.7%Co, 1.3%Rh | 0.15 |
| Present product 15 | 90%WC, 8.7%Co, 1.3%Ir | 0.15 |
| Present product 16 | 90%WC, 8.7%Co, 1.3%Ir | 0.15 |
| Comparative product 1 | 85%WC, 15%Co | 0 |
| Comparative product 2 | 90%WC, 10%Co | 0 |
| Comparative product 3 | 82%WC, 16%Co, 2%Ru | 0.13 |
| Comparative product 4 | 82%WC, 17.8%Co, 0.2%Ru | 0.01 |
| Comparative product 5 | 82%WC, 15.4%Co, 2.6%Ru | 0.17 |
| Comparative product 6 | 82%WC, 13%Co, 5%Ru | 0.38 |
| Comparative product 7 | 98.5%WC, 1%Co, 0.5%Ru | 0.50 |

The molded product of the mixture was charged in a sintering furnace. Thereafter, under a vacuum of 70 Pa or lower, a temperature in the sintering furnace was raised from room temperature to the sintering temperature T (°C) described at (a) of the following Table 2. When the temperature in the furnace became the sintering temperature T (°C), an argon gas was introduced into the furnace until a pressure in the furnace became the pressure P (Pa) described at (b) of Table 2. The state in the furnace was maintained in the argon atmosphere at the pressure of P (Pa) for 60 minutes. According to this procedure, the molded product of the mixture was sintered. Thereafter, the argon was discharged from the furnace, and the pressure in the furnace is made a vacuum of a pressure of 70 Pa or lower. The cooling rate R (°C/min) from the sintering temperature T (°C) to room temperature is as described in (c) of Table 2.

[Table 2]

| Sample No. | (a) Sintering temperature T(°C) | (b) Pressure in furnace P (Pa) | (c) Cooling rate R (°C/min.) |
|---|---|---|---|
| Present product 1 | 1500 | 200 | 30 |
| Present product 2 | 1400 | 500 | 30 |
| Present product 3 | 1400 | 800 | 30 |
| Present product 4 | 1400 | 200 | 20 |
| Present product 5 | 1400 | 200 | 10 |
| Present product 6 | 1400 | 200 | 5 |
| Present product 7 | 1400 | 200 | 30 |
| Present product 8 | 1400 | 200 | 30 |
| Present product 9 | 1400 | 200 | 30 |
| Present product 10 | 1400 | 200 | 5 |
| Present product 11 | 1400 | 200 | 30 |
| Present product 12 | 1400 | 200 | 5 |
| Present product 13 | 1400 | 200 | 30 |
| Present product 14 | 1400 | 200 | 5 |
| Present product 15 | 1400 | 200 | 30 |
| Present product 16 | 1400 | 200 | 5 |
| Comparative product 1 | 1400 | 200 | 30 |

(continued)

| Sample No. | (a) Sintering temperature T(°C) | (b) Cooling rate R (°C/min.) | (c) Pressure in furnace P (Pa) |
|---|---|---|---|
| Comparative product 2 | 1400 | 200 | 30 |
| Comparative product 3 | 1500 | 200 | 30 |
| Comparative product 4 | 1400 | 200 | 30 |
| Comparative product 5 | 1400 | 200 | 30 |
| Comparative product 6 | 1400 | 200 | 30 |
| Comparative product 7 | 1400 | 200 | 30 |

By sintering the molded product of the mixture, a cemented carbide could be obtained. By using a wet brush honing machine, a honing treatment was applied to the cutting edge of the obtained cemented carbide.

[Formation of coating layer]

A metal evaporation source was provided in a reaction vessel of an arc ion plating device. The composition of the metal evaporation source corresponds to the composition of the coating layer shown in Table 3. The produced cemented carbide was attached to the holder in the reaction vessel of the arc ion plating device. A pressure in the reaction vessel was made a vacuum of $1 \times 10^{-2}$ Pa or lower. The cemented carbide was heated by a heater in the furnace to a temperature of 500°C. After the temperature of the cemented carbide reached to 500°C, an Ar gas was introduced into the reaction vessel until the pressure in the reaction vessel became 5 Pa. A bias voltage of -1,000V was applied to the cemented carbide in the reaction vessel to carry out the Ar ion bombardment treatment onto the surface of the cemented carbide. The ion bombardment conditions are as follows.

Atmosphere in the reaction vessel: Ar atmosphere
Pressure in the reaction vessel: 5Pa

After the Ar ion bombardment treatment, the Ar gas was discharged and the pressure in the reaction vessel was made a vacuum of $1 \times 10^{-2}$ Pa or lower. Thereafter, an $N_2$ gas was introduced into the reaction vessel, and inside of the reaction vessel was made a nitrogen atmosphere with a pressure of 3 Pa. Next, the cemented carbide was heated to a temperature of 600°C by a heater in the furnace. After heating the cemented carbide, a bias voltage of -50V was applied to the cemented carbide and the metal evaporation source was evaporated by an arc discharge of 150A. According to this procedure, the coating layer shown in Table 3 was formed onto the surface of the cemented carbide. After forming the coating layer, the sample was cooled. After the sample temperature became 100°C or lower, the sample was taken out from the reaction vessel.

The obtained samples were mirror-polished in the vertical direction to the surface.

The mirror-polished surface was observed in the vicinity of the position of 50 μm toward the center part of the surface from the cutting edge of the surface opposed to the metal evaporation source. For observation of the mirror-polished surface, an optical microscope and FE-SEM were used. From the image of the observed mirror-polished surface, the thicknesses of the coating layer were measured at the three points. An average value of the thicknesses of the measured coating layer was calculated. The composition of the coating layer was measured by using EDS attached with FE-SEM and WDS attached with FE-SEM. The coating layer of the obtained sample was analyzed by X-ray diffraction of a 2θ/θ concentrated optical system using a Cu-Ka line. As a result, peaks of the cubic structure alone were observed and no peak of the hexagonal structure was observed.

[Table 3]

| Sample No. | Coating layer | |
|---|---|---|
| | Composition | Average thickness of whole coating layer (μm) |
| Present product 1 | $Ti_{0.5}Al_{0.5}N$ | 4.0 |
| Present product 2 | $Ti_{0.5}Al_{0.5}N$ | 4.0 |
| Present product 3 | $Ti_{0.5}Al_{0.5}N$ | 4.0 |
| Present product 4 | $Ti_{0.4}Al_{0.4}Cr_{0.2}N$ | 4.0 |

(continued)

| Sample No. | Coating layer | |
|---|---|---|
| | Composition | Average thickness of whole coating layer ($\mu$m) |
| Present product 5 | $Ti_{0.5}Al_{0.5}N$ | 4.0 |
| Present product 6 | $Ti_{0.5}Al_{0.5}N$ | 4.0 |
| Present product 7 | $Ti_{0.5}Al_{0.5}N$ | 4.0 |
| Present product 8 | $Ti_{0.6}Al_{0.4}N$ | 4.0 |
| Present product 9 | $Ti_{0.4}Al_{0.4}Si_{0.2}N$ | 4.0 |
| Present product 10 | TiN | 4.0 |
| Present product 11 | $Ti_{0.5}Al_{0.5}N$ | 4.0 |
| Present product 12 | $Ti_{0.5}Al_{0.5}N$ | 4.0 |
| Present product 13 | $Ti_{0.4}At_{0.4}Nb_{0.2}N$ | 4.0 |
| Present product 14 | $Ti_{0.4}Al_{0.4}Nb_{0.2}N$ | 4.0 |
| Present product 15 | $Ti_{0.5}Al_{0.5}N$ | 4.0 |
| Present product 16 | $Ti_{0.5}Al_{0.5}N$ | 4.0 |
| Comparative product 1 | $Ti_{0.4}Al_{0.4}Cr_{0.2}N$ | 4.0 |
| Comparative product 2 | $Ti_{0.5}Al_{0.5}N$ | 4.0 |
| Comparative product 3 | $Ti_{0.5}Al_{0.5}N$ | 4.0 |
| Comparative product 4 | $Ti_{0.5}Al_{0.5}N$ | 4.0 |
| Comparative product 5 | $Ti_{0.5}Al_{0.5}N$ | 4.0 |
| Comparative product 6 | $Ti_{0.5}Al_{0.5}N$ | 4.0 |
| Comparative product 7 | $Ti_{0.5}Al_{0.5}N$ | 4.0 |

Intensities $I_{Coc}$ and $I_{Coh}$ of the obtained sample were measured by X-ray diffraction of a $2\theta/\theta$ concentrated optical system using a Cu-Ka line. The measurement conditions are as follows.

Output: 50 kV, 250 mA,
Solar slit at incident side: 5°,
Divergence vertical slit: 2/3°,
Divergence vertical limit slit: 5 mm,
Scattering slit: 2/3°,
Solar slit at photoreception side: 5°,
Photoreception slit: 0.3 mm,
BENT monochromator,
Photoreception monochrome slit: 0.8 mm,
Sampling width: 0.01°,
Scanning speed: 1°/min,
$2\theta$ measurement range: 30 to 60°

More specifically, from the X-ray diffraction chart, an intensity $I_{Coc}$ of the (200) plane of the cubic Co and an intensity $I_{Coh}$ of the (101) plane of the hexagonal Co were obtained. In addition, a ratio of $I_{Coh}$ based on the total of $I_{Coc}$ and $I_{coh}$ [$I_{Coh}/(I_{Coh}+I_{Coc})$] was obtained. The results are shown in Table 4.
The obtained samples were mirror-polished in the vertical direction to the surface.
With regard to the mirror-polished surface, the cross-sectional structure from the surface of the cemented carbide to 500 $\mu$m inside thereof in the depth direction was observed by SEM attached with EDS.
Each composition of the hard phase and the binder phase of the cemented carbide was measured by EDS. A ratio of the hard phase and the binder phase of the cemented carbide was obtained from the results. The results are shown in Table 4.

Next, an image in which the cross-sectional structure of the mirror-polished surface was enlarged 5,000-fold by SEM was photographed. An average grain size of the hard phase was obtained from the photographed image by using the Fullman's equation (1). The results are shown in Table 4.

[Table 4]

| Sample No. | Cemented carbide | | | | | | | | | |
|---|---|---|---|---|---|---|---|---|---|---|
| | Hard phase | | | | | Binder phase | | | | |
| | WC (% by mass) | Compound | | Whole hard phase (% by mass) | Average grain diameter ($\mu$m) | Co (% by mass) | Platinum group element | | Whole binder phase (% by mass) | $I_{coh}/(I_{coh}+I_{coc})$ |
| | | Composition | (% by mass) | | | | Composition | (% by mass) | | |
| Present product 1 | 85 | - | - | 85 | 4.49 | 13 | Ru | 2 | 15 | 0.13 |
| Present product 2 | 88 | - | - | 88 | 2.56 | 10 | Ru | 2 | 12 | 0.17 |
| Present product 3 | 90 | - | - | 90 | 2.41 | 8.7 | Ru | 1.3 | 10 | 0.13 |
| Present product 4 | 90 | - | - | 90 | 2.42 | 8.7 | Ru | 1.3 | 10 | 0.18 |
| Present product 5 | 90 | - | - | 90 | 2.42 | 8.7 | Ru | 1.3 | 10 | 0.23 |
| Present product 6 | 90 | - | - | 90 | 2.44 | 8.7 | Ru | 1.3 | 10 | 0.26 |
| Present product 7 | 92 | - | - | 92 | 2.47 | 5 | Ru | 3 | 8 | 0.46 |
| Present product 8 | 97 | - | - | 97 | 2.34 | 2.5 | Ru | 0.5 | 3 | 0.17 |
| Present product 9 | 89.2 | $Cr_3C_2$ | 0.8 | 90 | 1.96 | 8.7 | Ru | 1.3 | 10 | 0.12 |
| Present product 10 | 89.2 | $Cr_3C_2$ | 0.8 | 90 | 1.97 | 8.7 | Ru | 1.3 | 10 | 0.21 |
| Present product 11 | 87.8 | (Ti, Ta)C | 2.2 | 90 | 2.17 | 8.7 | Ru | 1.3 | 10 | 0.12 |
| Present product 12 | 87.8 | (Ti, Ta)C | 2.2 | 90 | 2.19 | 8.7 | Ru | 1.3 | 10 | 0.23 |
| Present product 13 | 90 | - | - | 90 | 2.48 | 8.7 | Rh | 1.3 | 10 | 0.16 |

EP 3 147 377 B1

14

| Sample No. | Cemented carbide | | | | | | | | | |
| --- | --- | --- | --- | --- | --- | --- | --- | --- | --- | --- |
| | Hard phase | | | | | Binder phase | | | | |
| | WC (% by mass) | Compound | | Whole hard phase (% by mass) | Average grain diameter ($\mu$m) | Co (% by mass) | Platinum group element | | Whole binder phase (% by mass) | $I_{coh}/(I_{coh}+I_{coc})$ |
| | | Composition | (% by mass) | | | | Composition | (% by mass) | | |
| Present product 14 | 90 | - | - | 90 | 2.49 | 8.7 | Rh | 1.3 | 10 | 0.27 |
| Present product 15 | 90 | - | - | 90 | 2.44 | 8.7 | Ir | 1.3 | 10 | 0.14 |
| Present product 16 | 90 | - | - | 90 | 2.46 | 8.7 | Ir | 1.3 | 10 | 0.22 |
| Comparative product 1 | 85 | - | - | 85 | 3.01 | 15 | - | - | 15 | 0.04 |
| Comparative product 2 | 90 | - | - | 90 | 2.75 | 10 | - | - | 10 | 0.03 |
| Comparative product 3 | 85 | - | - | 82 | 7.35 | 16 | Ru | 2 | 18 | 0.11 |
| Comparative product 4 | 82 | - | - | 82 | 2.84 | 17.8 | Ru | 0.2 | 18 | 0.09 |
| Comparative product 5 | 82 | - | - | 82 | 2.65 | 15.4 | Ru | 2.6 | 18 | 0.14 |
| Comparative product 6 | 82 | - | - | 82 | 2.4 | 13 | Ru | 5 | 18 | 0.30 |
| Comparative product 7 | 98.5 | - | - | 98.5 | 2.22 | 1 | Ru | 0.5 | 1.5 | 0.38 |

Cutting test was carried out by using the obtained samples. The cutting test is a test to evaluate fracture resistance. The results of the cutting test are shown in Table 5.

[Cutting test]

Processing form: milling,
tool shape: RPHT10T3,
work piece material: Ti-6Al-4V,
shape of work piece material: 200 mm×1 10 mm×60 mm (shape: plate material), cutting speed: 60 m/min,
feed: 0.2 mm/tooth,
depth of cut: 2.5 mm,
cutting width: 20 mm
coolant: used,
evaluation item: a processed length until the sample causes fracture was measured.

[Table 5]

| Sample No. | Fracture resistance test |
|---|---|
| | Processed length (m) |
| Present product 1 | 0.83 |
| Present product 2 | 1.07 |
| Present product 3 | 1.04 |
| Present product 4 | 1.12 |
| Present product 5 | 1.25 |
| Present product 6 | 1.32 |
| Present product 7 | 0.99 |
| Present product 8 | 0.76 |
| Present product 9 | 0.79 |
| Present product 10 | 1.18 |
| Present product 11 | 0.84 |
| Present product 12 | 1.22 |
| Present product 13 | 0.94 |
| Present product 14 | 0.95 |
| Present product 15 | 0.89 |
| Present product 16 | 1.10 |
| Comparative product 1 | 0.50 |
| Comparative product 2 | 0.48 |
| Comparative product 3 | 0.58 |
| Comparative product 4 | 0.53 |
| Comparative product 5 | 0.64 |
| Comparative product 6 | 0.56 |
| Comparative product 7 | 0.32 |

From Table 5, processed lengths of Present products 1 to 16 were all 0.76 m or more. Present products had longer processed lengths than those of Comparative products. From the results, it can be understood that Present products are excellent in fracture resistance than those of Comparative products.

[Example 2]

[Formation of adhesive layer]

Cemented carbides produced simultaneously with the same furnace as those of Present products 1 to 16 in Example 1 were prepared, respectively.

A metal evaporation source was provided in a reaction vessel of an arc ion plating device. The composition of the metal evaporation source corresponds to the composition of the coating layer shown in Table 7.

The cemented carbides produced simultaneously with the same furnace as those of Present products 1 to 16 in Example 1 were each attached to the holder in the reaction vessel of the arc ion plating device. A pressure in the reaction vessel was made a vacuum of $1 \times 10^{-2}$ Pa or lower. The cemented carbide was heated by a heater in the furnace to a temperature of 500°C. After the temperature of the cemented carbide reached to 500°C, an Ar gas was introduced into the reaction vessel until the pressure in the reaction vessel became 5 Pa. A bias voltage of -1,000V was applied to the cemented carbide in the reaction vessel to carry out the Ar ion bombardment treatment onto the surface of the cemented carbide. The ion bombardment conditions are as follows.

Atmosphere in the reaction vessel: Ar atmosphere
Pressure in the reaction vessel: 5Pa

To the cemented carbides produced simultaneously with the same furnace as in Present products 1 to 16 of Example 1, the adhesive layer, or, the adhesive layer and the upper layer shown in Table 7 was/were formed to obtain Present products 17 to 32. Present products 17 to 32 correspond to Present products 1 to 16, respectively. That is, Present product 17 and Present product 1 are the cemented carbides produced simultaneously with the same furnace. Similarly, Present product 18 and Present product 2 are the cemented carbides produced simultaneously with the same furnace. Similarly, Present product 19 and Present product 3, ..., Present product 16 and Present product 32 are the cemented carbides produced simultaneously with the same furnace, respectively.

After the Ar ion bombardment treatment, the Ar gas was discharged from the reaction vessel and the pressure in the reaction vessel was made a vacuum of $1 \times 10^{-2}$ Pa or lower. Thereafter, an $N_2$ gas was introduced into the reaction vessel, and inside of the reaction vessel was made a nitrogen gas atmosphere with a pressure of 2 Pa. Next, according to the conditions of the nuclei forming process shown in Table 6, nuclei of the adhesive layer were so formed that the nuclei became the target thickness shown in Table 7. Thereafter, the adhesive layer shown in Table 7 was formed by the conditions of the film forming process shown in Table 6. With regard to Sample Nos. 19 and 20, after forming the adhesive layer, the samples were cooled, and after the sample temperature became 100°C or lower, the samples were taken out from the reaction vessel. The target thickness of the nuclei was obtained from the results of a growth rate by preliminarily examining the growth rate per a unit time under the conditions of the nuclei forming process.

With regard to Sample Nos. 17, 18 and 21 to 32, after forming the adhesive layer, the cemented carbide was heated to a temperature of 600°C by a heater in the furnace. Thereafter, an upper layer shown in Table 7 was formed onto the surface of the adhesive layer under the conditions of a bias voltage to be applied to the cemented carbide of -50V and an arc current of 150A. After forming the upper layer, the sample was cooled. After the sample temperature became 100°C or lower, the samples were taken out from the reaction vessel.

[Table 6]

| Sample No. | Nuclei forming process | | | Film forming process | | |
|---|---|---|---|---|---|---|
| | Bias voltage (V) | Arc current (A) | Temperature (°C) | Bias voltage (V) | Arc current (A) | Temperature (°C) |
| Present product 17 | -20 | 80 | 700 | -80 | 100 | 700 |
| Present product 18 | -20 | 80 | 700 | -80 | 100 | 700 |
| Present product 19 | -40 | 100 | 850 | -100 | 120 | 850 |

(continued)

| Sample No. | Nuclei forming process | | | Film forming process | | |
|---|---|---|---|---|---|---|
| | Bias voltage (V) | Arc current (A) | Temperature (°C) | Bias voltage (V) | Arc current (A) | Temperature (°C) |
| Present product 20 | -10 | 100 | 800 | -100 | 120 | 800 |
| Present product 21 | -10 | 100 | 800 | -100 | 120 | 800 |
| Present product 22 | -30 | 100 | 800 | -100 | 120 | 800 |
| Present product 23 | -30 | 100 | 800 | -100 | 120 | 800 |
| Present product 24 | -30 | 100 | 800 | -100 | 120 | 800 |
| Present product 25 | -30 | 100 | 800 | -100 | 120 | 800 |
| Present product 26 | -30 | 100 | 900 | -150 | 150 | 900 |
| Present product 27 | -30 | 100 | 800 | -100 | 120 | 800 |
| Present product 28 | -30 | 100 | 800 | -100 | 120 | 800 |
| Present product 29 | -30 | 100 | 800 | -100 | 120 | 800 |
| Present product 30 | -30 | 100 | 800 | -100 | 120 | 800 |
| Present product 31 | -30 | 100 | 850 | -100 | 120 | 850 |
| Present product 32 | -30 | 100 | 850 | -100 | 120 | 850 |

The obtained samples were mirror-polished in the vertical direction to the surface.

The mirror-polished surface was observed in the vicinity of the position of 50 μm toward the center part of the surface from the cutting edge of the surface opposed to the metal evaporation source. For observation of the mirror-polished surface, an optical microscope and FE-SEM were used. From the image of the observed mirror-polished surface, the thicknesses of each layer contained in the coating layer were measured at the three points. An average value of the thicknesses of the measured each layer was calculated. The total of the average thickness of each layer is the average thickness of the whole coating layer. The composition of the coating layer was measured by using EDS attached with FE-SEM and WDS attached with FE-SEM.

[Table 7]

| Sample No. | Coating layer | | | | | Average thickness of whole coating layer ($\mu$m) |
|---|---|---|---|---|---|---|
| | Adhesive layer | | | Upper layer | | |
| | Composition | Target thickness of nuclei (nm) | Average thickness ($\mu$m) | Composition | Average thickness ($\mu$m) | |
| Present product 17 | $Al_{0.66}Ti_{0.34}N$ | 100 | 3 | $Ti_{0.6}Al_{0.4}N$ | 1 | 4 |
| Present product 18 | $Al_{0.66}Ti_{0.34}N$ | 50 | 0.5 | $Ti_{0.6}Al_{0.4}N$ | 3 | 3.5 |
| Present product 19 | $Al_{0.7}Ti_{0.2}Cr_{0.1}N$ | 50 | 4 | - | - | 4 |
| Present product 20 | $Al_{0.7}Ti_{0.2}Si_{0.1}N$ | 50 | 7 | - | - | 7 |
| Present product 21 | $Al_{0.7}Ti_{0.2}W_{0.1}N$ | 50 | 3 | $Ti_{0.6}Al_{0.4}N$ | 0.5 | 3.5 |
| Present product 22 | $Al_{0.7}Ti_{0.2}Nb_{0.1}N$ | 50 | 3 | $Ti_{0.6}Al_{0.4}N$ | 1 | 4 |
| Present product 23 | $Al_{0.85}Ti_{0.15}N$ | 50 | 3 | $Ti_{0.6}Al_{0.4}N$ | 1 | 4 |
| Present product 24 | $Al_{0.85}Ti_{0.1}Cr_{0.05}N$ | 50 | 3 | $Ti_{0.6}Al_{0.4}N$ | 1 | 4 |
| Present product 25 | $Al_{0.85}Ti_{0.1}Y_{0.05}N$ | 50 | 2 | $Ti_{0.6}Al_{0.4}N$ | 0.5 | 2.5 |
| Present product 26 | $Al_{0.66}Ti_{0.34}N$ | 20 | 1.5 | $Ti_{0.6}Al_{0.4}N$ | 0.5 | 2 |
| Present product 27 | $Al_{0.66}Ti_{0.34}N$ | 20 | 3 | $Ti_{0.6}Al_{0.4}N$ | 1 | 4 |
| Present product 28 | $Al_{0.66}Ti_{0.34}N$ | 100 | 3 | $Ti_{0.6}Al_{0.4}N$ | 1 | 4 |
| Present product 29 | $Al_{0.66}Ti_{0.34}N$ | 50 | 3 | $Ti_{0.6}Al_{0.4}N$ | 1 | 4 |
| Present product 30 | $Al_{0.66}Ti_{0.34}N$ | 50 | 3 | $Ti_{0.6}Al_{0.4}N$ | 1 | 4 |

(continued)

| Sample No. | Coating layer | | | | | Average thickness of whole coating layer (μm) |
|---|---|---|---|---|---|---|
| | Adhesive layer | | | Upper layer | | |
| | Composition | Target thickness of nuclei (nm) | Average thickness (μm) | Composition | Average thickness (μm) | |
| Present product 31 | $Al_{0.66}Ti_{0.34}N$ | 50 | 3 | $Ti_{0.6}Al_{0.4}N$ | 1 | 4 |
| Present product 32 | $Al_{0.66}Ti_{0.34}N$ | 50 | 3 | $Ti_{0.6}Al_{0.4}N$ | 1 | 4 |

Intensities $I_c$ and $I_h$ of the obtained samples were measured by X-ray diffraction of a $2\theta/\theta$ concentrated optical system using a Cu-Ka line. The measurement conditions are as follows.

Output: 50 kV, 250 mA,
Solar slit at incident side: 5°,
Divergence vertical slit: 2/3°,
Divergence vertical limit slit: 5 mm,
Scattering slit: 2/3°,
Solar slit at photoreception side: 5°,
Photoreception slit: 0.3 mm,
BENT monochromator,
Photoreception monochrome slit: 0.8 mm,
Sampling width: 0.01°,
Scanning speed: 1°/min,
$2\theta$ measurement range: 30 to 70°

More specifically, from the X-ray diffraction chart, an intensity $I_c$ of the (200) plane of the cubic structure of the adhesive layer and an intensity $I_h$ of the (100) plane of the hexagonal structure of the adhesive layer were obtained. In addition, a ratio of $I_h$ based on the total of $I_c$ and $I_h$ $[I_h/(I_h+I_e)]$ was obtained. The results are shown in Table 8.

[Table 8]

| Sample No | Adhesive layer |
|---|---|
| | $I_h/(I_h+I_c)$ |
| Present product 17 | 0.08 |
| Present product 18 | 0.10 |
| Present product 19 | 0.24 |
| Present product 20 | 0.22 |
| Present product 21 | 0.22 |
| Present product 22 | 0.22 |
| Present product 23 | 0.25 |
| Present product 24 | 0.25 |
| Present product 25 | 0.25 |
| Present product 26 | 0.29 |
| Present product 27 | 0.27 |
| Present product 28 | 0.11 |

(continued)

| Sample No | Adhesive layer |
|---|---|
| | $I_h/(I_h+I_c)$ |
| Present product 29 | 0.16 |
| Present product 30 | 0.16 |
| Present product 31 | 0.19 |
| Present product 32 | 0.19 |

The obtained samples were mirror-polished in the vertical direction to the surface. More specifically, from the surface of the adhesive layer of the samples to the depth of 100 nm was polished by a diamond paste. Further, the adhesive layer was mirror-polished by using colloidal silica.

With regard to Sample Nos. 17, 18 and 21 to 32, the upper layer was polished from the surface toward the inside until the adhesive layer was exposed. Further, the adhesive layer was mirror-polished until unevenness of the adhesive layer was eliminated. The surface structure of the mirror-polished adhesive layer was observed by EBSD. Setting of EBSD is as follows.

Step size: 0.01 $\mu$m,
Measured range: 2 $\mu$m$\times$2 $\mu$m,

A boundary with an orientation difference of 5° or more is regarded as grain boundary

According to the following procedure, an average grain diameter of the adhesive layer was measured from an image observed by EBSD.

First, the grain diameter of the adhesive layer was obtained from the image observed by EBSD. The grain diameter herein mentioned means a diameter of a circle (circle equivalent diameter) of an area equal to an area of a crystal grain in the adhesive layer. According to the same method, the grain diameters of a plural number of the crystal grains contained in the visual field of the observed image were obtained. An average value of the grain diameters of a plural number of the crystal grains was calculated. The calculated average value is an average grain diameter of the adhesive layer. The results are shown in Table 9.

[Table 9]

| Sample No. | Adhesive layer |
|---|---|
| | Average grain diameter (nm) |
| Present product 17 | 348 |
| Present product 18 | 360 |
| Present product 19 | 146 |
| Present product 20 | 278 |
| Present product 21 | 282 |
| Present product 22 | 265 |
| Present product 23 | 198 |
| Present product 24 | 202 |
| Present product 25 | 210 |
| Present product 26 | 15 |
| Present product 27 | 262 |
| Present product 28 | 258 |
| Present product 29 | 268 |
| Present product 30 | 255 |
| Present product 31 | 126 |

(continued)

| Sample No. | Adhesive layer |
| --- | --- |
| | Average grain diameter (nm) |
| Present product 32 | 134 |

By using the obtained samples, a cutting test was carried out. In the cutting test, fracture resistance of the samples was evaluated by the same cutting conditions as in Example 1. The results of the cutting test were shown in Table 10.

In addition, differences between the processed lengths of the samples having the adhesive layer (Present products 17 to 32) and the processed lengths of the samples having no adhesive layer (Present products 1 to 16) were obtained. The results are shown in Table 10.

The difference of the processed lengths was calculated as follows.

Present product 17: the difference between the processed length of Present product 17 and the processed length of Present product 1

Present product 18: the difference between the processed length of Present product 18 and the processed length of Present product 2

Present product 19: the difference between the processed length of Present product 19 and the processed length of Present product 3

Present product 32: the difference between the processed length of Present product 32 and the processed length of Present product 16

[Cutting test]

Processing form: milling,
tool shape: RPHT10T3,
work piece material: Ti-6Al-4V,
shape of work piece material: 200 mm× 110 mm×60 mm (shape: plate material), cutting speed: 60 m/min,
feed: 0.2 mm/tooth,
depth of cut: 2.5 mm,
cutting width: 20 mm,
coolant: used,
evaluation item: a processed length until the sample causes fracture was measured.

[Table 10]

| Sample No. | Fracture resistance test | Difference in processed length between sample having adhesive layer and sample having no adhesive layer |
| --- | --- | --- |
| | Processed length (m) | |
| Present product 17 | 0.93 | 0.10 |
| Present product 18 | 1.18 | 0.11 |
| Present product 19 | 1.30 | 0.26 |
| Present product 20 | 1.27 | 0.15 |
| Present product 21 | 1.46 | 0.21 |

(continued)

| Sample No. | Fracture resistance test | Difference in processed length between sample having adhesive layer and sample having no adhesive layer |
|---|---|---|
| | Processed length (m) | |
| Present product 22 | 1.57 | 0.25 |
| Present product 23 | 1.22 | 0.23 |
| Present product 24 | 1.00 | 0.24 |
| Present product 25 | 0.96 | 0.17 |
| Present product 26 | 1.31 | 0.13 |
| Present product 27 | 1.10 | 0.26 |
| Present product 28 | 1.36 | 0.14 |
| Present product 29 | 1.12 | 0.18 |
| Present product 30 | 1.14 | 0.19 |
| Present product 31 | 1.16 | 0.27 |
| Present product 32 | 1.37 | 0.27 |

From Table 10, processed lengths of Present products 17 to 32 were all 0.93 m or more. Present products had processed lengths longer than those of Comparative products. From the results, it can be understood that Present products are excellent in fracture resistance than those of Comparative products.

All of Present products 17 to 32 having the adhesive layer had longer processed lengths than those of Present products having no adhesive layer. The reason can be considered that minute chipping which becomes an origin of fracture is suppressed by improving adhesiveness between the cemented carbide and the coating layer.

Industrial applicability

The coated cemented carbide of the present invention are excellent in fracture resistance than the conventional ones. The coated cemented carbide of the present invention can be suitably utilized, in particular, as cutting tools for processing difficult-to-cut materials. Therefore, the coated cemented carbide of the present invention have high industrial applicability.

**Claims**

1. A coated cemented carbide comprising a cemented carbide and a coating layer formed on a surface of the cemented carbide,
   wherein the cemented carbide comprises 85% by mass or more and 97% by mass or less of a hard phase, and 3% by mass or more and 15% by mass or less of a binder phase, wherein a total amount of the hard phase and the binder phase is 100% by mass, and wherein
   the hard phase

(i) is tungsten carbide or
(ii) has tungsten carbide as a main component and further contains a balance amount of a compound comprising at least one kind of a metal element selected from the group consisting of Ti, Zr, Hf, V, Nb, Ta, Cr and Mo, and at least one kind of an element selected from C and N,

the binder phase contains Co, and at least one kind of a platinum group element selected from the group consisting of Ru, Rh, Pd, Os, Ir and Pt,
in peaks of the Co obtained by an X-ray diffraction analysis, an intensity $I_{Coc}$ at a (200) plane of cubic Co and an intensity $I_{Coh}$ at a (101) plane of hexagonal Co satisfy a relation of the following formula (1),

$$0.1 \leq [I_{Coh}/(I_{Coh}+I_{Coc})] \leq 0.6 \cdots (1);$$

wherein an amount of the Co contained in the binder phase is 2.5% by mass or more and 14.5% by mass or less, and an amount of the platinum group element contained in the binder phase is 0.5% by mass or more and 4% by mass or less;
wherein an average grain diameter of the hard phase is 0.5 $\mu$m or more and 5 $\mu$m or less, wherein the average grain diameter of the hard phase is obtained by applying Fullman's equation d=(4/$\pi$)·(NL/NS) to an image of a polished cross-section of the cemented carbide in which a cross-sectional structure of the cemented carbide is enlarged by Scanning Electron Microscopy, SEM, to 2,000 to 10,000-fold, wherein d is the average grain size, $\pi$ is the circular constant, NL is a number of the hard phase per a unit length hit by a straight line on the cross-sectional structure, and NS is a number of the hard phase contained in a unit area;
wherein
the coating layer contains at least one layer of an adhesive layer(s),
the adhesive layer is formed on a surface of the cemented carbide,
the adhesive layer has a composition represented by the formula: $Al_xTi_yM_zN$,
wherein M represents at least one kind of an element selected from the group consisting of Zr, Hf, V, Nb, Ta, Cr, Mo, W, Y, B and Si, and x, y and z represent atomic ratio of Al, Ti and M element respectively based on the total amount of Al, Ti and M elements, and 0.65$\leq$x$\leq$0.9, 0.1$\leq$y$\leq$0.35, 0$\leq$z$\leq$0.2, and x+y+z=1, in peaks of the adhesive layer obtained by an X-ray diffraction analysis, an intensity $I_c$ at a (200) plane of cubic structure and an intensity $I_h$ at a (100) plane of hexagonal structure satisfy a relation of the following formula (2).

$$0.05 \leq [I_h/(I_h+I_c)] \leq 0.3 \cdots (2)$$

wherein the condition of X-ray for both binder phase and adhesive layer are specified in the description.

2. The coated cemented carbide according to Claim 1, wherein an average thickness of the adhesive layer is 0.5 $\mu$m or more and 7 $\mu$m or less.

3. The coated cemented carbide according to Claim 1 or Claim 2, wherein an average grain diameter of the adhesive layer is 10 nm or more and 400 nm or less.

4. The coated cemented carbide according to any one of Claims 1 to 3, wherein an average thickness of the coating layer is 0.5 $\mu$m or more and 10 $\mu$m or less.

**Patentansprüche**

1. Beschichtetes Sinterkarbid, aufweisend ein Sinterkarbid und eine Überzugsschicht, die auf einer Oberfläche des Sinterkarbids gebildet ist,
wobei das Sinterkarbid 85 Massen-% oder mehr und 97 Massen-% oder weniger einer Hartphase sowie 3 Massen-% oder mehr und 15 Massen-% oder weniger einer Bindephase aufweist, wobei eine Gesamtmenge der Hartphase und der Bindephase 100 Massen-% beträgt, und wobei
die Hartphase

(i) Wolframcarbid ist, oder

(ii) Wolframcarbid als Hauptbestandteil aufweist und ferner eine restliche Menge einer Verbindung enthält, die zumindest eine Art eines Metallelements, das ausgewählt ist aus der Gruppe bestehend aus Ti, Zr, Hf, V, Nb, Ta, Cr und Mo, und zumindest eine Art eines Elements aufweist, das aus C und N ausgewählt ist,

die Bindephase Co sowie zumindest eine Art eines Platinmetall-Elements enthält, das ausgewählt ist aus der Gruppe bestehend aus Ru, Rh, Pd, Os, Ir und Pt,
in Peaks des Co, die mittels einer Röntgenbeugungsanalyse erhalten werden, eine Intensität $I_{Coc}$ an einer (200) Ebene von kubischem Co und eine Intensität $I_{Coh}$ an einer (101) Ebene von hexagonalem Co eine Beziehung der folgenden Formel (1) erfüllen,

$$0,1 \leq [I_{Coh}/(I_{Coh}+I_{Coc})] \leq 0,6 \ldots (1);$$

wobei eine Menge des Co, das in der Bindephase enthalten ist, 2,5 Massen-% oder mehr und 14,5 Massen-% oder weniger beträgt, und eine Menge des Platinmetall-Elements, das in der Bindephase enthalten ist, 0,5 Massen-% oder mehr und 4 Massen-% oder weniger beträgt;
wobei ein durchschnittlicher Korndurchmesser der Hartphase 0,5 $\mu$m oder mehr und 5 $\mu$m oder weniger beträgt, wobei der durchschnittliche Korndurchmesser der Hartphase durch Anwenden der Fullman-Gleichung d = (4/$\pi$) · (NL/NS) auf ein Bild eines polierten Querschnitts des Sinterkarbids erhalten wird, in dem eine Querschnittsstruktur des Sinterkarbids mittels Elektronenrastermikroskopie, SEM, 2000-fach bis 10000-fach vergrößert ist, wobei d die durchschnittliche Korngröße ist, $\pi$ die Kreiszahl ist, NL eine Anzahl der Hartphase pro Längeneinheit ist, die von einer Geraden auf der Querschnittsstruktur getroffen wird, und NS eine Anzahl der Hartphase ist, die in einer Flächeneinheit enthalten ist;
wobei
die Überzugsschicht mindestens eine Schicht einer Haftvermittlerschicht(en) enthält, die Haftvermittlerschicht auf einer Oberfläche des Sinterkarbids gebildet ist,
die Haftvermittlerschicht eine Zusammensetzung aufweist, die durch die Formel $Al_xTi_yM_zN$ repräsentiert wird,
wobei M zumindest eine Art eines Elements repräsentiert, das ausgewählt ist aus der Gruppe bestehend aus Zr, Hf, V, Nb, Ta, Cr, Mo, W, Y, B und Si, und x, y und z ein Atomverhältnis eines Al-, Ti- und M-Elements repräsentieren, jeweils basierend auf der Gesamtmenge der Al-, Ti- und M-Elemente, und 0,65 $\leqq$ x $\leqq$ 0,9, 0,1 $\leqq$ y $\leqq$ 0,35, 0 $\leqq$ z $\leqq$ 0,2, und x+y+z = 1 gilt,
in Peaks der Haftvermittlerschicht, die mittels einer Röntgenbeugungsanalyse erhalten wurden, eine Intensität $I_c$ an einer (200) Ebene einer kubischen Struktur und eine Intensität $I_h$ an einer (100) Ebene einer hexagonalen Struktur eine Beziehung der folgenden Formel (2) erfüllen:

$$0,05 \leqq [I_h/(I_h+I_c)] \leqq 0,3 \ldots (2);$$

wobei die Röntgenbedingungen sowohl für die Bindephase als auch die Haftvermittlerschicht in der Beschreibung angegeben sind.

**2.** Beschichtetes Sinterkarbid nach Anspruch 1, wobei eine durchschnittliche Dicke der Haftvermittlerschicht 0,5 $\mu$m oder mehr und 7 $\mu$m oder weniger beträgt.

**3.** Beschichtetes Sinterkarbid nach Anspruch 1 oder Anspruch 2, wobei ein durchschnittlicher Korndurchmesser der Haftvermittlerschicht 10 nm oder mehr und 400 nm oder weniger beträgt.

**4.** Beschichtetes Sinterkarbid nach einem der Ansprüche 1 bis 3, wobei eine durchschnittliche Dicke der Überzugsschicht 0,5 $\mu$m oder mehr und 10 $\mu$m oder weniger beträgt.

**Revendications**

**1.** Carbure cémenté revêtu comprenant un carbure cémenté et une couche de revêtement formée sur une surface du carbure cémenté,
dans lequel le carbure cémenté comprend 85 % en masse ou plus et 97 % en masse ou moins d'une phase dure, et 3 % en masse ou plus et 15 % en masse ou moins d'une phase liante, dans lequel une quantité totale de la phase dure et de la phase liante est 100 % en masse, et dans lequel
la phase dure

(i) est du carbure de tungstène ou
(ii) comprend du carbure de tungstène comme composant principal et contient en outre une quantité restante d'un composé comprenant au moins un type d'un élément métallique choisi dans le groupe constitué par Ti, Zr, Hf, V, Nb, Ta, Cr et Mo, et au moins un type d'un élément choisi parmi C et N,

la phase liante contient du Co, et au moins un type d'un élément du groupe du platine choisi dans le groupe constitué par Ru, Rh, Pd, Os, Ir et Pt,
dans les pics du Co obtenus par analyse par diffraction des rayons X, une intensité $I_{Coc}$ au niveau d'un plan (200) de Co cubique et une intensité $I_{Coh}$ au niveau d'un plan (101) de Co hexagonal satisfont à une relation de la formule (1) suivante,

$$0,1 \leqq [I_{Coh}/(I_{Coh} + I_{Coc})] \leqq 0,6 \qquad (1) \; ;$$

dans lequel une quantité du Co contenu dans la phase liante représente 2,5 % en masse ou plus et 14,5 % en masse ou moins, et une quantité de l'élément du groupe du platine contenu dans la phase liante représente 0,5 % en masse ou plus et 4 % en masse ou moins ;
dans lequel un diamètre de grain moyen de la phase dure est de 0,5 $\mu$m ou plus et de 5 $\mu$m ou moins, dans lequel le diamètre de grain moyen de la phase dure est obtenu par l'application de l'équation de Fullman d = (4/$\pi$) (NL/NS) à une image d'une section transversale polie du carbure cémenté dans lequel une structure transversale du carbure cémenté est agrandie par microscopie électronique à balayage, SEM, 2 000 à 10 000 fois, dans lequel d est la taille de grain moyenne, $\pi$ est la constante circulaire, NL est un nombre de la phase dure par unité de longueur heurtée par une ligne droite sur la structure transversale et NS est un nombre de la phase dure contenue dans une surface unitaire ;
dans lequel
la couche de revêtement contient au moins une couche d'une ou plusieurs couches adhésives,
la couche adhésive est formée sur une surface du carbure cémenté,
la couche adhésive a une composition représentée par la formule : $Al_xTi_yM_zN$, dans laquelle M représente au moins un type d'un élément choisi dans le groupe constitué par Zr, Hf, V, Nb, Ta, Cr, Mo, W, Y, B et Si, et x, y et z représentent respectivement un rapport atomique de Al, Ti et l'élément M sur la base de la quantité totale de Al, Ti et l'élément M, et
$0,65 \leqq x \leqq 0,9, 0,1 \leqq y \leqq 0,35$,
$0 \leqq z \leqq 0,2$, et $x + y + z = 1$,
dans les pics de la couche adhésive obtenus par une analyse par diffraction des rayons X, une intensité $I_c$ au niveau d'un plan (200) de structure cubique et une intensité $I_h$ au niveau d'un plan (100) de structure hexagonale satisfont à une relation de la formule (2) suivante,

$$0,05 \leqq [I_h/(I_h + I_c)] \leqq 0,3 \qquad (2) \; ;$$

dans lequel les conditions des rayons X pour à la fois la phase liante et la couche adhésive sont spécifiées dans la description.

2. Carbure cémenté revêtu selon la revendication 1, dans lequel une épaisseur moyenne de la couche adhésive est de 0,5 $\mu$m ou plus et de 7 $\mu$m ou moins.

3. Carbure cémenté revêtu selon la revendication 1 ou la revendication 2, dans lequel un diamètre de grain moyen de la couche adhésive est de 10 nm ou plus et de 400 nm ou moins.

4. Carbure cémenté revêtu selon l'une quelconque des revendications 1 à 3, dans lequel une épaisseur moyenne de la couche de revêtement est de 0,5 $\mu$m ou plus et de 10 $\mu$m ou moins.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010207955 A
- JP 2004181604 A
- US 20130105231 A1
- EP 1452621 A2

**Non-patent literature cited in the description**

- **A. F. LIVOSKII.** SINTERED METALS AND ALLOYS CEMENTED CARBIDES ALLOYED WITH RUTHENIUM, OSMIUM, AND RHENIUM. *Powder Metallurgy and Metal Ceramics,* 2000, vol. 39 (9-10), 428-432